# EUROPEAN PATENT SPECIFICATION

(11) **EP 4 511 699 B1**
(45) Date of publication and mention of the grant of the patent: **18.02.2026**
(21) Application number: 23720815.2
(22) Date of filing: 18.04.2023
(51) Int. Cl.: G03F 7/00

(54) **METHOD AND SYSTEM FOR DETECTING AND/OR QUANTIFYING MANUFACTURING INACCURACIES**
VERFAHREN UND SYSTEM ZUR ERKENNUNG UND/ODER QUANTIFIZIERUNG VON FERTIGUNGSUNGENAUIGKEITEN
PROCÉDÉ ET SYSTÈME DE DÉTECTION ET/OU DE QUANTIFICATION D'ERREURS DE FABRICATION

(30) Priority: 20.04.2022 SE 2250477
(43) Date of publication of application: 26.02.2025
(73) Proprietor: DAPPLER LABS AB, 129 32 Hägersten (SE)
(72) Inventor: RAJA, Shyamprasad Natarajan, 12932 Hägersten (SE); DUBOIS, Valentin, 114 18 Stockholm (SE)
(74) Representative: Høiberg P/S
(86) International application number: PCT/EP2023/060018
(87) International publication number: WO 2023/203025

(56) References cited:
- WO-A1-2016/172122
- WO-A1-2018/137925
- WO-A1-2020/020759
- WO-A1-2021/165419

## Description

The present disclosure relates to a method for detecting and/or quantifying manufacturing inaccuracies made by a lithographic process. The disclosure further relates to a metrology system.

### Background

A lithographic apparatus is commonly used in the manufacture of integrated circuits and applies a designed pattern onto a substrate. Typical substrates are semiconductor substrates, such as Si. The transfer of the pattern is performed by irradiating a radiation-sensitive layer of material (resist) homogeneously deposited on the substrate. Known lithographic apparatus include electron beam writers, laser beam writers, steppers, and scanners. Each of these tools translate a computer-aided design (CAD) to a pattern on a resist on a substrate, which is an essential part of the fabrication of semiconductor devices. Electron beam writers use rastering of a beam of electrons focused to a single spot of a few nanometers to expose part of the resist where the features of interest will form, while scanner uses a wide area beam of light that is modulated by a mask to achieve selective exposure of the resist. The image of the mask projected onto the substrate is reduced by optics, such as lenses in deep ultraviolet (DUV) or mirrors in extreme ultraviolet (EUV). In the case of DUV, it is light transmitted through the mask that matters, whereas in EUV, the mask is a mirror, and it is light which is reflected by the mask that matters. In the semiconductor industry, electron beam lithography is mainly used to pattern the features on masks. Scanners use masks to perform the photolithography steps at high speed and wafer throughput. Masks are also a typical substrate on top of which writing-based lithography is carried out to transfer a design to a pattern onto a substrate where devices will be produced. Multibeam variants of beam writers exist.

All lithographic apparatuses suffer from a wide range of inaccuracies which introduces minute differences between what is designed in a CAD file and the pattern on the substrate. These inaccuracies affect the placement, shape, dimensions, and roughness of the patterns produced on wafers, which ultimately affect the performance and yield of semiconductor devices. Some of these types of inaccuracies are called edge placement errors (EPEs), and include overlay (OV; the measurement of pattern-to-pattern displacement between layers), critical dimensions (CD, including local critical dimension, LCD, and critical dimension uniformity, CDU), registration (REG; the pattern position with respect to an absolute grid), and any roughness type (including line edge roughness, LER, and line width roughness, LWR) and stochastics.

Any EPE present at any level, from the sub-device level, device-level, system-level, die-level up to wafer and batch-level, induced by any mask, lithographic apparatus, lithographic process, and other apparatus or process steps involved in the creation of the structures accumulates after several masks to induce a potentially large mismatch between the intended design and the actual design on the substrate that may strongly affect the yield of fabricated devices. A defect is defined as any physical, electrical, or parametric deviation capable of affecting yield. Due to the increasing number of individual process steps and masks and the need for denser features, maintaining a low number of defects requires a tighter and tighter EPE budget, which demands stringent metrology, control and mitigation schemes of EPEs at every step and level for every mask and lithographic apparatus.

Electron beam lithography suffers from various sources of inaccuracies that introduce EPEs such as imperfect beam focus and astigmatism, diffraction and spherical and chromatic aberrations, beam deflection hysteresis, stage errors (including stitching, non-orthogonality, and calibration errors), overlay misalignment, registration errors, proximity effects, charging effects, fogging effects, heating effect, etc., as well as drift during exposure in several of the beam properties, such as focus, astigmatism, XY positioning and calibration of deflection of the beam, among others.

Apart from EPEs which originate from writing the mask, mask-based lithography using scanners suffers from various sources of inaccuracies which may further impact EPEs such as shot noise, overlay misalignment, optical proximity effects, phase-shift effects, source mask optimization errors, illumination errors, pupil errors, flare effect, shadowing effect, imperfect focusing, wafer and reticle bow and thermal expansion, wafer clamping, reticle clamping, pellicle induced distortion, dose errors, imperfect rastering, stage (reticle and wafer stage) errors, tool matching, among others.

Apart from inaccuracies arising during exposure of the resist on the substrate, a wide range of other inaccuracies and defects in the resist may be found as result of resist baking and development, resist erosion during dry etching as well as local stochastic defects such as microbridges and broken lines, missing contacts and broken contacts, stochastic effects, material quality, among others. Dry etching also introduces inaccuracies that affect overlay, CD and LCDU among others, such as wafer edge effects, non-uniformity and drift in etch rate and etch direction, redeposition, resist hardening, microloading, pitch walk, etch bias, among others. Additionally, 3D effects also affect EPEs when many layers are stacked onto one another.

All these sources of inaccuracies accumulate after each processing step and introduce various EPEs in the final devices which affect fabrication yields and the density at which devices are made, and must be detected, studied and minimized to increase fabrication yields and overall device performances.

Metrology tools that can detect and quantify any of these EPEs play an important role in process control and risk mitigation in the production of semiconductor devices. Metrology tools also play a crucial role in the research and development activities, and production ramping, aimed at optimizing the operating conditions of lithographic apparatus and other apparatus involved in the fabrication of semiconductor devices to maximize yield, lower cost, increase device density and improve performance. As the density of nanofabricated features are increasing and feature sizes are decreasing, the development of metrology tools to detect and quantify these errors at the single digit nanometer level and sub-nanometer level is crucial to tell whether the tools work as expected (monitoring), and if not, what the source of the error or inaccuracy is (troubleshooting).

There are two main classes of techniques relevant in this context: inspection and metrology. Inspection techniques look for defects typically using optical microscopy to detect defects of nano scale, micron scale or larger (such as particles), while metrology techniques measure critical dimensions and coordinates (absolute and relative) of specific features or sub-features on a substrate being patterned to either assess the fidelity of pattern transfer or to ensure proper overlay of subsequent patterns to pre-existing ones, among others. As semiconductor manufacturing techniques continue to evolve to smaller and smaller critical dimensions, metrology has to be performed on nanometric features and has to be capable of achieving extremely high resolution and precision at high throughput, otherwise important sources of patterning variability may be detected too late in production and lead to defective chips. Of importance to the semiconductor industry is the ability to measure EPEs to perform process control or in order to leverage any actionable process correction in any tool or process step, such as higher order scanner corrections, that may improve the final yield and performance for the fabricated devices.

Two broad types of techniques are used to perform critical dimension and overlay metrology today: (1) imaging-based (optical or scanning electron microscopy) and (2) scattering-based (scatterometry, OCD).

Optical scattering-based metrology, called scatterometry, derives shape, dimension and composition information from the scattering patterns observed in light that has interacted with a sample. It requires a regular array of similar features, which may be an in-circuit feature, such as a line array, or a specially designed measurement target, typically located in the area between dies on the wafer (also known as the scribe line). Scatterometry is typically implemented using dedicated grating structures (regularly spaced array of lines and spaces) as measurement targets, where the interference patterns of monochromatic light interacting with the grating is analysed to derive information about critical dimensions and overlay with sub-nanometer precision. A typical metrology application involves performing a series of scattering measurements at different wavelengths of optical excitation.

Critical-dimension scanning electron microscopy (CD-SEM) is a direct measurement technique and works by carrying out measurements using computational image processing of scanning electron microscopy (SEM) images of patterns-typical examples being the width and pitch of an array of lines, or the diameter and pitch of an array of holes. This technique, which operates in vacuum, is typically used to measure critical dimensions of patterns as well as to quantify other types of important lithographic defects such as stochastic errors (missing holes, broken lines, etc.) and LER. Optical microscopy using wavelength tunable light sources of specifically designed targets is used in a technique known as image-based overlay to perform overlay metrology.

Scatterometry and other OCD techniques require specialized optical equipment including coherent wavelength tunable light sources and spectrometers to work. They typically operate on a single spot at a time rather than an area. Some of these techniques also require special types of grating structures of certain micrometer sizes to work, which limits their utility for device metrology. CD-SEM runs typically on capital intensive equipment and has a very low throughput due to the very high magnification required to resolve the sub-nanometric features. Furthermore, each of these techniques suffer from inherent noise, inaccuracies or errors of origin in the imaging and detection components of the tools, calibration of the tools, as well as the computation that leads to the final metrology data such as image processing, modelling, and fitting.

In summary, the available metrology techniques are low throughput and require complex and expensive tooling and rely on sophisticated data analysis, which limits the frequency and density of metrology performed for process control and monitoring.

WO 2018/137925 A1 (STICHTING VU) discloses a method for measuring a structure on a substrate, the structure being located beneath at least one layer deposited on the substrate, the method comprising: illuminating an excitation area of the substrate with excitation radiation at an excitation time, wherein the excitation radiation causes a material effect to interact with the substrate, and wherein the excitation radiation forms a spatial pattern on a surface of the substrate; measuring at least one effect associated with a scattered material effect scattered by the structure; and deriving at least one characteristic of the structure based on the at least one measured effect. The alignment marks are buried underneath opaque layers and exposed to excitation radiation. The interaction between the excitation radiation and the alignment marks creates temporary effects on the surface.

### Summary

A lithographic system inevitably introduces errors in where and how the edges of patterns are placed on a substrate, so called edge placement errors (EPEs). Detection and quantification of EPEs is crucially important as they undesirably affect all micro and nano fabricated structures and have historically been responsible for major yield issues in the semiconductor industry. In the present disclosure a new metrology approach is described, which binarizes EPEs into discretely identifiable physical events on the substrate where the lithography is done. This methodology, which is compatible with all lithographic systems and independent from all the other existing metrology techniques, expands the toolbox available to sense and quantify errors of lithographic origin alongside the SEM, TEM, AFM, and diffraction-based techniques.

The present disclosure relates to a method and a system that addresses at least some of the aforementioned limitations.

The disclosure relates to, according to a first embodiment, a method for detecting and/or quantifying manufacturing inaccuracies made by a lithographic process, comprising the steps of:
providing at least one design for fabrication of structures on a substrate using a set of lithographic processes, wherein the fabricated structures define an array of metrology sensors, wherein each metrology sensor is adapted to produce one of a known and finite set of possible distinct and discrete physical events upon application of a physical process, wherein the produced physical event:
   is unknown before the application of the physical process,
   is dependent on manufacturing inaccuracies generated by at least one of the set of lithographic processes,
   is a displaced state of the fabricated structure, or has one or more physical entities associated with the fabricated structures present that were absent before the application of the physical process, and
   is larger than the inaccuracies;
applying the set of lithographical processes to obtain the fabricated structures;
applying the physical process, thereby producing one of the known and finite set of possible distinct and discrete physical events for each metrology sensor;
reading out the produced physical events of all metrology sensors; and
processing the produced physical events of all metrology sensors to detect and/or quantify manufacturing inaccuracies made by the lithographic process,
wherein, after having performed said steps, each metrology sensor contains data about the inaccuracies made by the lithographic process.

A person skilled in the art is familiar with lithographic systems and processes and would be able to carry out the examples of such processes referred to in the disclosure.

By imaging the metrology sensors such as described in the last step of the method previously disclosed, it is possible to perform metrology relevant to semiconductor manufacturing at nanometric resolution using basic optical microscopy. This is a cost and time-effective method compared to the existing metrology techniques previously described. The disclosed method may be further configured to produce a new stream of metrology data that is independent from all other metrology techniques previously described, which may be used to efficiently detect, study, control and minimize any of the aforementioned sources of EPEs of origin in masks, lithographic apparatus, etching and deposition processes and tools.

The disclosed method may be used in a scanner qualification process. It may further be used on a patterning control process.

Advantageously, this method can be said to conduct nanoscale experiments each of whose outcome, which is either the displacement of matter (liquid or solid) to its displaced state, or is the creation of one or more physical entities whose number or placement, is sensitive to a lithographic pattern and its errors. The geometry and size of the lithographic pattern can be thought of as the analog signal containing the EPEs that will be processed by the experiment to detect EPEs. The displacement of the matter or the number or placement of the physical entities constitutes the outcome of the experiment in the form of a binary (when the set of all possible physical events is equal to two) or discrete (when the set of all possible physical events is more than two) signal that each metrology sensor produces and that depends on the lithographic pattern and its deviations from an ideal design. After performing the different steps of the method, each metrology sensor contains data about the inaccuracies introduced by the overall lithographic process, including the contribution of the lithographic apparatus, in a binary or discretized format, comparable to an analog-to-digital converter. When one of these lithographic processes has a dominant contribution to the metrology sensor, the metrology sensors contain data about that specific lithographic process. By fabricating the at least one pattern as described, and applying the physical process, the method can be said to replace computer-based data processing with a number of parallel physical processes that perform analog-to-digital conversion on a substrate. The method enables the option of using imaging to collect the data produced by the metrology sensors into a computer. As long as the resolution and the signal to noise ratio of the imaging system (determined by the magnification, illumination intensity, the camera and the exposure settings used, among others) is sufficient to detect the discretized data produced by the metrology sensors on the substrate, the metrology data becomes independent from the imaging technique, its associated calibration, and computer-based data processing.

In the presently disclosed method, information pertaining to EPEs is advantageously processed and binarized on the substrate by means of experiments sensitive to patterns on the substrates defined by the lithographic processes and apparatus. Imaging may be used to collect the already discretized data on the substrate for statistical analysis in a computer. Thus, the method described can be said to perform the measurement of EPEs prior to digitization of the data in a computer.

In the present method, data processing of EPEs can thus be said to precede the imaging, or the digitization of the data in a computer. This is in contrast to conventional metrology techniques, for which data processing of EPEs needs to be carried out algorithmically or using machine learning methods by a computer after digitization of data into a computer, and therefore follows the imaging or inspection step. The present method generates universally readable metrology data, with no further sources of errors or inaccuracies in the metrology data introduced after the binarizing experiments involving displaceable matter or the creation of physical entities have taken place on the substrate. The only requirement is that the result of each binarization experiment can be correctly registered to the corresponding pattern in the original design. This is in sharp contrast to conventional metrology techniques which are susceptible to a wide range of errors and inaccuracies introduced by the sensing/imaging system as well as by computational modelling and analysis, whereby the final measurements extracted depend on the steps involved in the creation of the metrology data starting from the arrangement of the excitation and imaging system, the digitization process to the computer-based data processing, such as individual components such as lenses and detectors, calibration methods, measurement conditions and parameters, as well as models and algorithms. For example, unlike in the present method, model-based measurement techniques, such as interferometry and scatterometry, use experimental data and simulations of the underlying physics to extract quantitative estimates of the measurands of a specimen based upon a parametric model of that specimen. The uncertainties of these estimates are based upon not only the uncertainties in the experimental data, but also the sensitivity of that data to the model parameters, parametric correlations among those parameters, and fitting, among others.

In the present disclosure, the EPE measurement data, written in a stable physical bitmap format on-chip, can be collected by imaging at a much lower spatial resolution than the length scale of the errors, as they are encoded and binarized in much larger physical bits. Conceptually, this is similar to the principle of a barcode: the data is encoded in a string of bits and presented in a simple visual format that is machine readable. The method of the present disclosure is similar to printing a two-dimensional barcode (such as a QR-code) with ink on paper where the barcode actually printed depends on the errors made by the printer, and the ink is revealed only after a certain process is applied (in our case, a stressor, or more generally, a physical process). The deviation of the revealed barcode from the one expected can be readily determined and used to compute EPEs. In this analogy, the printer is a lithographic tool, the paper is a semiconductor substrate with one or more layers of materials which can be patterned, and the ink pattern encoding information is a physical bit that results from the binarizing experiment on each metrology sensor. While the type of EPE information (CDU, overlay etc) encoded is determined by the design of the specific type of pattern that is printed on the substrate, the form of the physical bit remains the same for the same combination of substrate and physical process. In other words, the encoding and printing process of the barcode remains the same while permitting encoding different types of EPE information. Although the physical bits may be larger than 200 nm, and thus be readable with a basic optical microscope (as can be found in some wafer inspection equipment), the data stored in the bitmap can encode metrology data about EPE at a precision better than 10 nm (i.e., even EPE of magnitude 10 nm and smaller can be detected and quantified using this method). Additionally, as long as the readout technique is able to discriminate the individual physical bits and register the bits to the patterns in the design used to produce them, the entirety of the metrology data can be retrieved without errors irrespective of the imaging technique or microscope used, given proper instructions are known or given to correctly interpret the string of bits. Since the entirety of the metrology data is present in the physical bits on the substrate, no improved calibration, magnification or contrast in imaging the physical bits will improve measurement accuracy and precision: the measurement data becomes free from photonic and electronic bias or noise of origin in image acquisition. Different microscopes imaging the same bitmap will be able to read exactly the same metrology data. In this way, it can be said that the measurement of EPE is carried out prior to imaging. Imaging is only needed to read or digitize the already-processed metrology data and process it into a qualitative or quantitative measurement.

The metrology data produced by the present method is independent from many limitations that normally plague optical techniques. For example, in the present invention, optical microscopy, whose resolution is normally limited by the wavelength of the light and the lenses used, can sense local EPEs at the sub-10 nm level on a single isolated structure. This is because, if a metrology sensor was designed in a way that we expect a specific bit, but, after binarization, we find a different bit, we know an error in patterning has been made in that specific metrology sensor.

The metrology data produced by the present method is independent from many limitations that normally plague CD-SEM and CD-AFM. For example, in the present invention, no complex image processing is necessary to obtain size and shape information about patterns from images, which is the case in CD-SEM and CD-AFM. In the present invention, only simple image processing that can detect the binary or discrete data, whose format is already known, from the metrology sensors is needed. Furthermore, in the present invention, the size of pixels for imaging only needs to be sufficiently large to resolve the binary or discrete data from the metrology sensor, and can be orders of magnitude larger than the pixels in a CD-SEM and CD-AFM which need to resolve the nanometric features of interest. Therefore, the effective physical size of each imaged pixel in the present case can be orders of magnitude larger than the length scale at which EPE information is being resolved. This leads to great savings in data acquisition throughput, data storage and data processing. Furthermore, detection and measurement of nanometric or sub-nanometric EPEs is possible to do on wafer-scale thanks to compatibility with high-throughput inspection optical microscopes or wafer inspection tools used in semiconductor foundries. Using this method, it is thus possible to capture wafer-level signatures of nanometric EPEs at a high wafer throughput. Additionally, with the presently described method, different imaging systems will be able to read the same metrology data from the same EPE measurement with no added noise or bias. This is in sharp contrast to all other metrology techniques where measurement data is inevitably sensitive to all the downstream hardware components involved in the digitization of the pattern information containing the EPEs and the software layer which computes measurement data from the digitized data. Such hardware may include the illumination source, filters, lenses, beam rastering system, mechanical stage, CMOS sensor, etc, and software may include physical equations, physical constants, CAD, meshing, edge detection algorithm, parametrization, fitting etc. In other metrology techniques, any systematic or random errors introduced by any of these components or steps affect the accuracy and precision of the final metrology data. As a result, two different metrology tools may yield significantly different measurements of the same error if not properly calibrated. Two different image processing algorithms or physical models may yield different measurements from the same raw digitized data. Aberrations caused by tool optics are arguably the main source of systematic errors in image-based metrology, which our method is insensitive to in much the same way as a barcode reader.

The ability to produce data that is independent from other metrology techniques and their inherent errors strongly supports hybrid metrology and may be used to enhance, monitor or calibrate the performance of any existing metrology technique used with lithographic patterning and lithographic processes.

In one embodiment, the metrology sensor comprises a plurality of mechanical actuators connected by at least one linking element in a strained state representing the resting state, wherein each mechanical actuator is adapted to trigger a mechanical actuation to reach an end state in a predefined amount of time upon initiation of an etching process, and wherein each linking element reaches an unstrained state representing the displaced state when one of the mechanical actuators reaches its end state, and wherein the step of simultaneously applying the physical stressor to each metrology sensor for at least a predefined period of time comprises simultaneously etching the array of metrology sensors for at least a predefined period of time.

In this embodiment, an expected result of the actuations of the mechanical actuators is known since the actuators are designed to behave in a specific way. The mechanical actuators can be thought of as timers. When the first of the timer reaches its end state, it may trigger the mechanical actuation, which will leave the linking element in the displaced state. When the mechanical actuation is triggered, the linking element may be physically displaced towards one of the mechanical actuators, the one that has not actuated or has actuated later than the other one. In this state, the optical microscope may provide an image of a whole area covering a number of metrology sensors, thereby getting instant detailed information about manufacturing inaccuracies made by a lithographic apparatus by analysing deviations from the expected result.

The present disclosure further relates to a metrology system comprising:
a lithographic apparatus configured to pattern a radiation sensitive resist, such as a polymer, on a substrate to fabricate a structure using a design comprising an array of metrology sensors, wherein each metrology sensor is adapted to produce one of a known and finite set of possible distinct and discrete physical events upon application of a physical process, wherein the produced physical event:
   is unknown before the application of the physical process,
   is dependent on manufacturing inaccuracies generated by the lithographic apparatus, and
   is a displaced state of the fabricated structure, or has one or more physical entities associated with the fabricated structures present that were absent before the application of the physical process,
   is larger than the inaccuracies,
   wherein, after having performed said steps, each metrology sensor contains data about the inaccuracies made by the lithographic process;
a system adapted to apply the physical process to each metrology sensor.

Advantageously, by using the metrology system previously described, metrological information obtained from the metrology sensors may be derived by rapid image recognition processing (such as template matching) which would be applied to a subset of pixels in the total imaged area due to a priori knowledge of the position of the metrology sensors on the surface of the patterned substrate being observed.

### Description of the drawings

The invention will in the following be described with reference to the accompanying drawings. The drawings are examples of embodiments and not limiting to the presently disclosed metrology sensor assembly, metrology system and method for detecting and/or quantifying manufacturing inaccuracies made by a lithographic apparatus. As an example, the metrology sensors are generally said to be adapted to produce one of a known and finite set of possible distinct physical events upon application of a physical process. The drawings may show examples of mechanical actuators.
Fig. 1A-C show an example of a metrology sensor in different states.
Fig. 2A-D shows an embodiment of the presently disclosed metrology sensor using mechanical actuators.
Fig. 3 shows a further embodiment of the presently disclosed metrology sensor.
Fig. 4A-B shows an example of an array of metrology sensors distributed on a substrate after the application of the physical process and the resulting bitmap translation of the binarized physical events after applying Boolean logic.
Fig. 5A-H shows an embodiment of the presently disclosed metrology sensor, wherein the displaceable matter is comprised by a liquid or gel.
Fig. 6 shows an illustration of how mechanical actuators or extremity areas of a gel or liquid can be used to represent timers used in the presently disclosed metrology sensors.
Fig. 7A-B shows a further illustration of how the timers can be used to obtain physical records, or more generally physical events, on the substrate that can be used to detect and/or quantify manufacturing inaccuracies made by a lithographic process.
Fig. 8A-B shows an example of a pattern cut in two separate but complementary parts that can be made into a whole complete metrology sensor for detecting misalignment between two separate exposures.
Fig. 9 shows an example of a flow chart of the presently disclosed method for detecting and/or quantifying manufacturing inaccuracies made by a lithographic process.

### Detailed description

The present disclosure relates to a method for detecting and/or quantifying manufacturing inaccuracies made by a lithographic process. The manufacturing inaccuracies may be, for example, edge placement errors, including CD, CDU, LCDU, overlay, registration, roughness and stochastics.

Preferably, in a first step, at least one design for fabrication of structures on a substrate using a set of lithographic processes is provided. The fabricated structures may define an array of metrology sensors, wherein each metrology sensor is adapted to produce one of a known and finite set of possible distinct physical events upon application of a physical process. The produced physical event may be unknown before the application of the physical process, dependent on manufacturing inaccuracies generated by at least one of the set of lithographic processes, and may be displaced state of the fabricated structure or have one or more physical entities associated with the fabricated structures present that were absent before the application of the physical process. The set of lithographical processes may then be applied to obtain the fabricated structures. The physical process may then be applied to producing one of the known and finite set of possible distinct physical events for each metrology sensor. After that the produced physical events of all metrology sensors can be read out and the produced physical events of all metrology sensors can be processed to detect and/or quantify manufacturing inaccuracies made by the lithographic process. The produced physical events may be digitally stored. The produced physical events of all metrology sensors may be read out using, for example, imaging.

The metrology sensor may be configured such that the produced physical events are conveniently larger than the inaccuracies themselves. In this way the inaccuracies can be read indirectly by, for example, imaging at a much lower spatial resolution than the length scale of the errors. The manufacturing inaccuracies may originate from an edge placement error, wherein the edge placement error is smaller than 5 nm, or wherein the edge placement error is smaller than 1 nm.

A lithographic process can generally be said to involve transferring a design pattern to a substrate using, for example, an exposure tool and subsequent resist development. In a single run and without using prior knowledge of metrology, manufacturing inaccuracies resulting from the overall lithographic process can be determined. When used holistically in combination with other metrology tools, or with prior knowledge about the relative magnitudes of different error sources producing manufacturing inaccuracies, it is possible to quantify the exact contribution of a specific apparatus or process step. In this manner, a specific lithographic process and physical process can be made in such a way that the contribution to overall manufacturing inaccuracies due to the exposure tool is the dominant one. Similarly, when using an extremely well calibrated and stable exposure tool, it is possible to quantify the inaccuracies due to a dry etching or wet etching process. In one embodiment the set of lithographic processes includes at least exposure and development of a radiation-sensitive resists.

According to one example, at least one lithography pattern for fabrication of structures on a substrate is provided by a lithographic apparatus, defining an array of metrology sensors. In this example, each metrology sensor comprises displaceable matter configured in a resting state and distributed over a local area, wherein the displaceable matter is adapted to reach a displaced state towards a predefined discrete position within the local area in a displacement process upon application of a physical stressor. A physical stressor may be an etching process or any suitable physical process that causes the displaceable matter to reach the displaced state, including, for example, changing a temperature or phase, or applying vibrations or evaporation. The displaceable matter of said fabricated metrology sensors is fabricated originally in a resting state. In a further step, a physical stressor is applied to each metrology sensor for at least a predefined period of time. In a further step, the metrology sensors are imaged to collect the data for detection and quantification of any inaccuracy made by the lithographic apparatus.

A lithographic apparatus may be an electron beam writer, a laser beam writer, a nanoimprint, a stepper, a scanner, or others used in the field of device nanofabrication. A lithographic apparatus is not necessarily an exposure tool, but can also be a pattern-transfer tool, such as a tool applying dry etching or wet etching. A lithographic process shall be construed to broadly cover any suitable use of one or more steps using a lithographic apparatus. One advantage of the presently disclosed method, system and sensor is that any lithographic apparatus may be used, and thus metrology data from any lithographic apparatus may be produced. The technology is not dependent on a specific lithographic apparatus. It can be said that presently disclosed method and system may turn any lithographic apparatus into a metrology apparatus that generates metrology data about itself, whereby no other metrology tool, apart from itself, is needed to produce the metrology data, i.e. only lithographic processes are used to produce metrology data. By moving the data processing to the substrate, any lithographic apparatus or work of the lithographic apparatus may be assessed using imaging, such as an optical microscope. The substrate on which the structure is placed may be a rigid semiconductor substrate, such as silicon or germanium, metals such as aluminum or gold, oxides such as SiO₂ or sapphire or quartz, or any substrate used in the field of device nanofabrication and semiconductor manufacturing.

A fabricated structure within the context of the present disclosure may be a resist, polymer, solid-state, liquid, gel or stacked, or a combination of these materials.

A physical event may be a change in optical property, change in shape, change in size, change in placement in XY or Z, a buckling/bending mode, etc. in whole or part of a structure or added visible entity. It may stem from removal or addition of a material. The actual physical event type is known to the operator before the application of the physical process and depends on the pattern, substrate and physical process. Different event types can be used individually or simultaneously, and the same combination of pattern, substrate and physical process can trigger more than one type of physical event. As stated, each metrology sensor is adapted to produce one of a known and finite set of possible distinct physical events upon application of a physical process. Examples of physical events include events wherein a structure in the metrology sensor produces no, one, or several visible entities in the vicinity of structure that was not present prior to applying the physical process, for example, scattering point for light, such as a crack, a hole or a particle. Further examples of physical events include a visible and discretely quantifiable alteration of the structure itself, or of another structure that is derived from the structure, such a shrink-expansion in area, movement towards the left or right, twisted clockwise or counter clockwise, buckled up or down, etc. In one embodiment, the physical event is a change in shape, size or placement of a part of or the whole of the structure, preferably wherein the change in shape, size or placement of a part of or the whole of the structure is larger than 10 nm.

A physical process within the context of the present disclosure may comprise mechanically stressing, releasing internal stress, spin-coating, selective deposition, selective photo exposure, selective etching, heating, freezing, stressing by bending substrate, bimorph displacement, exposure to radiation of a specific wavelength, ultrasonic or megasonic vibration, and combinations of one or more of the aforementioned physical processes, for example, selective etching, followed by selective deposition.

The step of reading out the produced physical events of all metrology sensors can be done in several ways. The readout may involve imaging-based readout, discrete sampling, including laser, for example, used in the same way as a barcode reader, scatterometry, or SEM used in local 'probe' mode.

In one embodiment of the presently disclosed method for detecting and/or quantifying manufacturing inaccuracies made by a lithographic process, the produced physical events are visibly distinguishable from the other physical events of the known and finite set of possible distinct physical events. This may be achieved, for example, by having metrology sensors that comprise displaceable matter configured in a resting state and distributed over a local area, wherein the displaceable matter is adapted to reach a displaced state within the local area in a displacement process upon application of the physical process. The displaceable matter may be in the resting state when the fabricated structures on the substrate is obtained from the lithographic apparatus. As stated, the physical process may involve a number of techniques. In one embodiment, the physical process is applied to each metrology sensor for a predefined period of time.

The step of processing the produced physical events may comprise computationally processing the produced physical events. For example, the processing may comprise the step of applying Boolean logic to the produced physical events from the at least one design based on expected physical event results and/or the step of constructing probability distributions of counts of produced physical events against one or more varied design parameters for the design and comparing them against the expected probability distribution based on the nominal designs.

The step of reading out the produced physical events may comprise searching for the physical event only at predefined locations of the fabricated structure.

In one embodiment of the presently disclosed method for detecting and/or quantifying manufacturing inaccuracies made by a lithographic process, the at least one design is configured such that one specific physical event is favored. This may be done, for example, by providing two or more designs, wherein at least one of the designs is distinguishable from the other design by at least one edge displaced by an integer number of the smallest controllable step size of the lithographic apparatus. Alternatively, the at least one design may be configured such that none of the known and finite set of distinct physical events is favored.

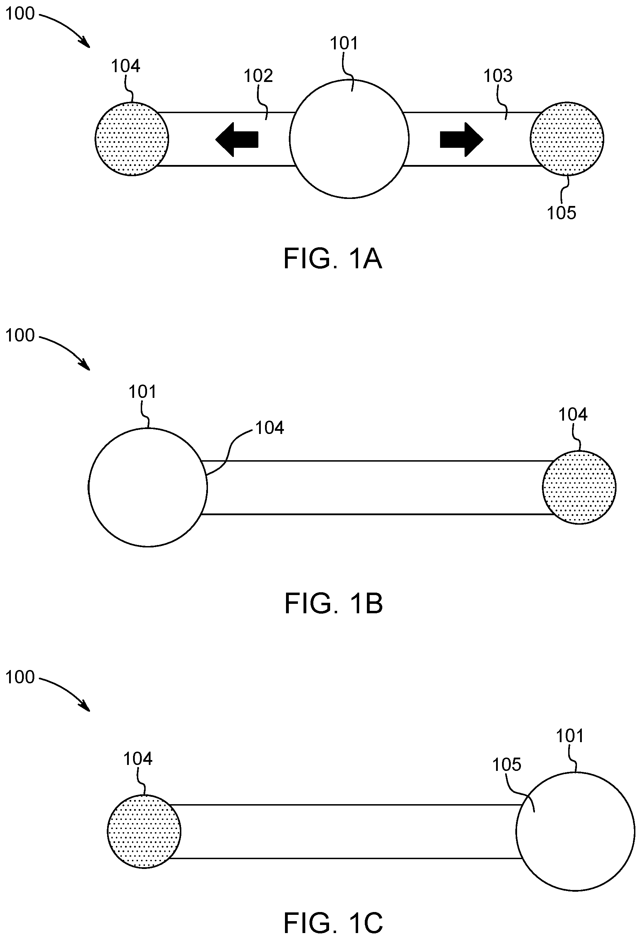

Fig. 1A shows a non-limiting conceptual example of a metrology sensor 100 in a resting state. The drawing shows two possible displaced states 104 and 105, which correspond to possible distinct physical events. The displaceable matter 101 is in a resting state. From this position a physical process can be applied to move displaceable matter 101 in predefined directions 102 and 103 to reach one of the two possible displaced states 104 and 105. Fig. 1B and Fig. 1C show the metrology sensor 100, wherein the displaceable matter 101 is in each of the possible end states 104 and 105.

As stated, the step of reading out the produced physical events of all metrology sensors can be done, for example, by imaging. Imaging the metrology sensors after having applied the physical process to displace the displaceable matter allows to identify the position of the displaceable matter in the end state. Such imaging comprises the determination of the position of the linking elements, preferably by means of optical microscopy. Other microscopy techniques such as electron, ion, ultra violet or X-ray microscopy could also be used to perform the imaging step.

In an embodiment, the material comprising the mechanical actuators is isotropically or anisotropically etchable in contact with an etchant agent in a wet etching or a dry etching process. It is understood by an isotropically etchable material a material that is etched at a constant rate, independently of properties such as size, crystal direction, crystal polarity or roughness. For example, aluminium oxide is a material isotropically etchable under contact with liquid HF or Aluminium etchant. It is understood by an anisotropically etchable material a material that is etched at a rate depending on crystal properties such as crystal direction, crystal polarity or roughness. For example, specific crystal planes in crystalline Si can be etched at a much slower rate under certain etching agents, such as the (111) planes in contact with KOH or TMAH.

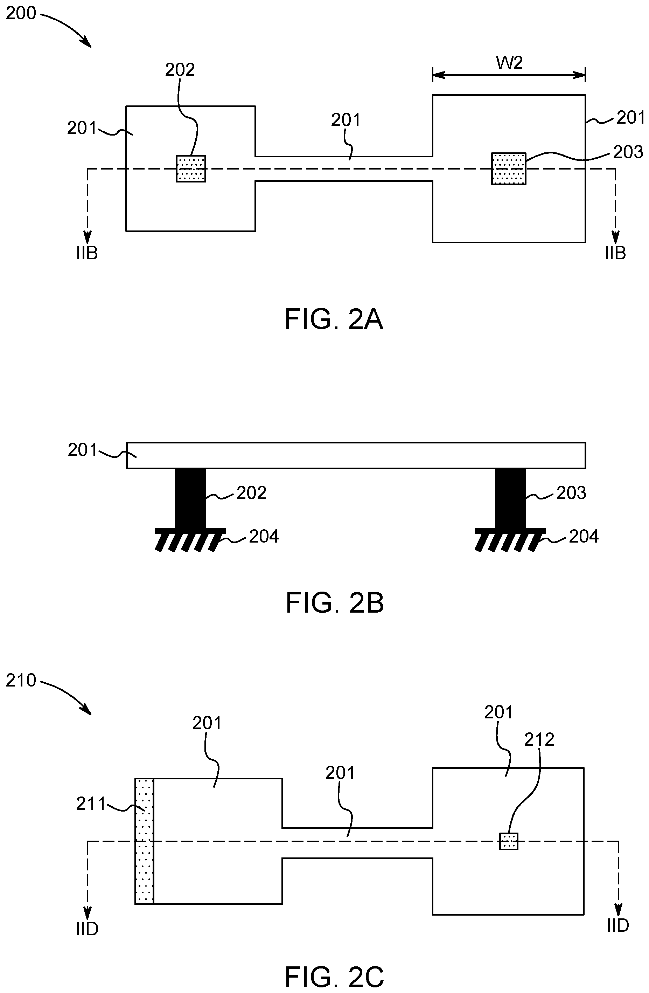

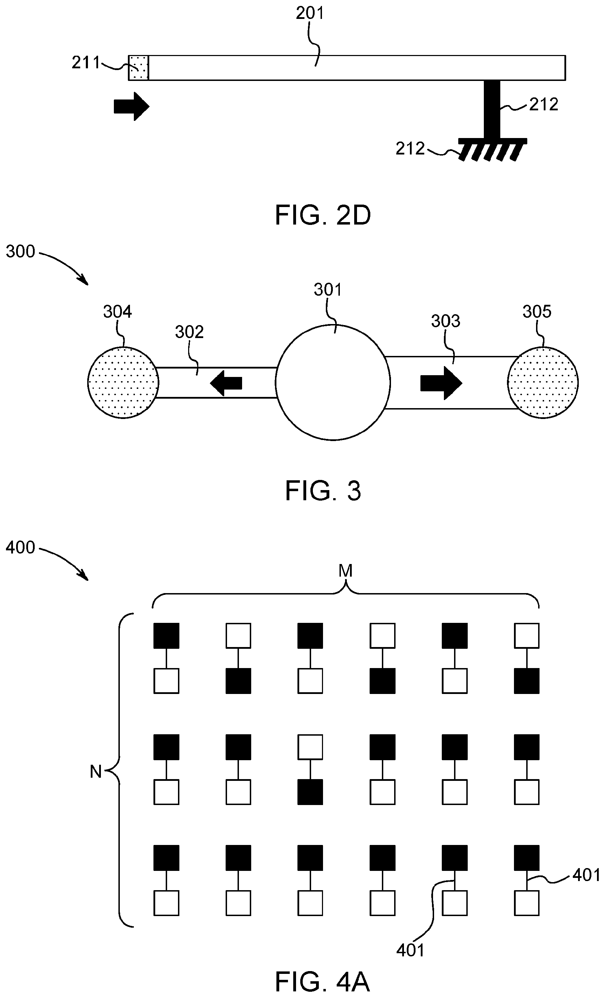

Fig. 2A shows an embodiment of a metrology sensor 200 comprising mechanical actuators in the form of vertical nano-pillars 202 and 203 disposed on the substrate 204. The mechanical actuators are fixed to a rigid substrate 204 and to a linking element 201, as shown in Fig. 2B. The linking element 201, connecting both mechanical actuators, comprises a rigid platform made of a material non-reactive to an etchant agent, thereby making it possible to selectively etch away the mechanical actuators.

Initially, the linking element 201 in Fig. 2A and Fig. 2B is in a pre-strained state and connected to the mechanical actuators 202 and 203. Such pre-strained states can be induced, for example, by fabricating the linking elements at a temperature higher than room temperature and made of a material having a higher thermal expansion coefficient than that of the substrate. Fig. 2C shows the result after an etching process removes at least one of the mechanical actuators of the metrology sensor 210, while the linking elements 201 are preferably made of a material mostly insensitive to the etchant. Upon application of the physical stressor to the metrology sensor 210, the linking elements are displaced a distance 211 from the strained state towards the remaining mechanical actuator 212 of the metrology sensor to an unstrained position, as shown in Fig. 2C. The driving force of the displacement of the linking element can be for example a tensile stress like thermal strain generated in the linking element during the fabrication process. The end state of a mechanical actuator corresponds to a partial or complete etching of the mechanical actuator, to a degree that it releases the linking element to which it is connected. This may include that the linking element physically detaches from the mechanical actuator before full release, due to a high pulling force. The mechanical actuators are, preferably, laterally and isotropically etched by an etchant agent, preferably in a wet etch process, such as hydrofluoric acid or aluminium etchant. Other wet etchants may be used depending on the material composition of the nano-pillars, such as KOH, TMAH, H2SO4 or piranha etching. The etching process can be stopped at a desired time by drying or submerging the substrate in etch stopping liquids, like deionized water among others.

In another embodiment, the linking elements - which may alternatively be referred to as beams - are pre-strained elements connected to at least two mechanical actuators within a metrology sensor. The linking elements may be disposed in the pre-strained state on top of the actuators. When the time required for the first actuator to act elapses, the linking element will get released from the substrate and the tensile stress will pull it towards the other actuator which has not yet elapsed and consequently remains attached to the substrate at the moment of displacement. The experienced displacement of the linking element from the first elapsed actuator leaves a physical record on the substrate, as well as simultaneously releases the stress in the metrology sensor, thereby preventing the other actuator from creating its own physical record once it has elapsed. The displacement of the linking element from the actuator that has elapsed first can later be detected, allowing to know which of the actuator elapsed first.

The displacement direction may be reversed when the stress is compressive. The displacement direction may be out-of-plane when the linking element has a stress gradient or consists of a bimorph. Hence, a lithographic method is described in the present disclosure to define 'timers' on chip and create a system to make them mutually exclusive, such that, of two or more connected actuators, only the actuator which elapses first can generate displacement from its predefined location and therefore leave a physical record while the other connected actuators will stay in place even after they eventually elapse.

The physical event may be a fracture that is created through a fracture mechanism induced by the displaceable matter moving from the resting state to the displaced state. The fracture may be created by the linking element pulling a mechanical actuator. The pulling may induce a tear in the layer it is attached to, leaving a fracture gap in that layer. This fracture gap may be used for selective etching of the layer below, which forms a pit that is optically observable. This fracture gap may also be used for selective growth of a material using layer below as seed material, thus creating a particle that is optically observable. Thus, the created fracture gap may be used to selectively and spatially amplify data about the displaced state which simplifies collecting the data by imaging. Such gaps, pits and particles are non-limiting examples of physical entities created in association with the fabricated structures which did not exist before the application of a physical process. Physical entities created in association with the fabricated structures and displaced state of the fabricated structures are examples of known and finite set of possible distinct physical events triggered upon application of a physical process.

In the case of one linking element metrology device connecting two mechanical actuators, a uni-dimensional displacement is achieved. However, a plurality of actuators might be linked with a plurality of linking elements, allowing to record a physical displacement in any direction within the plane of the surface of the substrate.

In a further embodiment, the displaceable matter of each metrology sensor comprises liquid or gel, wherein the liquid or gel is displaced to the displaced state upon application of the physical stressor, and wherein the step of simultaneously applying the physical stressor to each metrology sensor for at least a predefined period of time comprises simultaneously changing a temperature or phase of the liquid or gel or the substrate, or applying vibrations or evaporation.

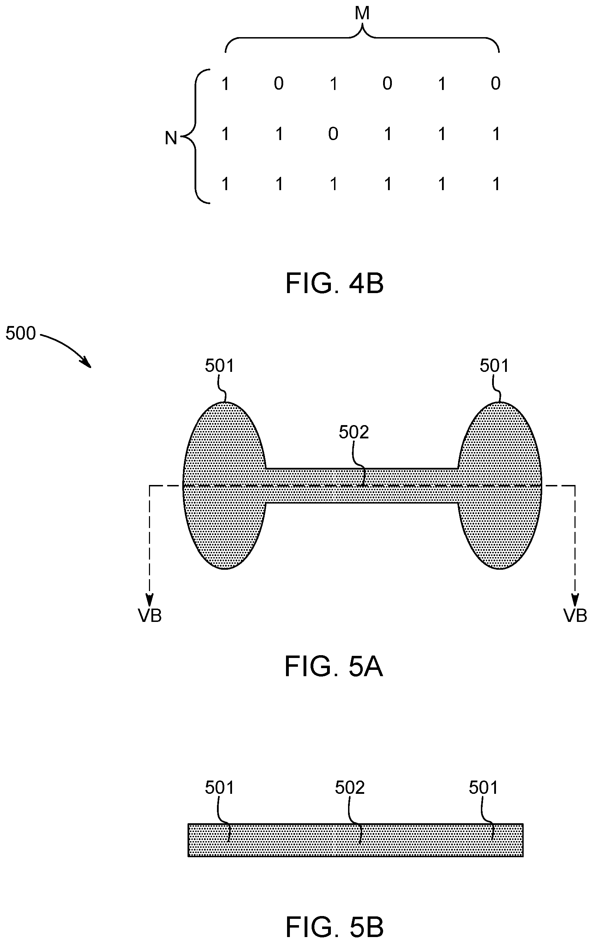

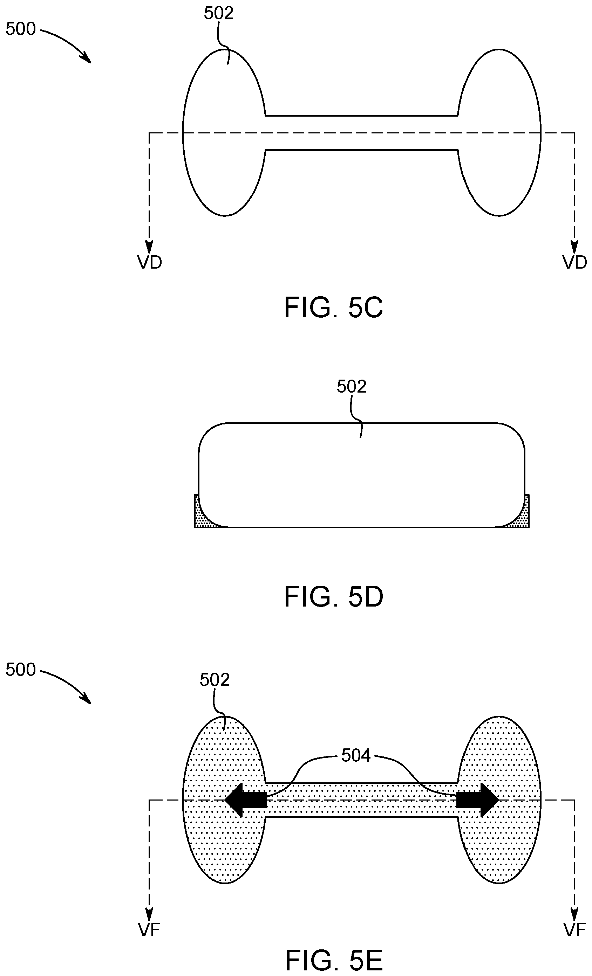

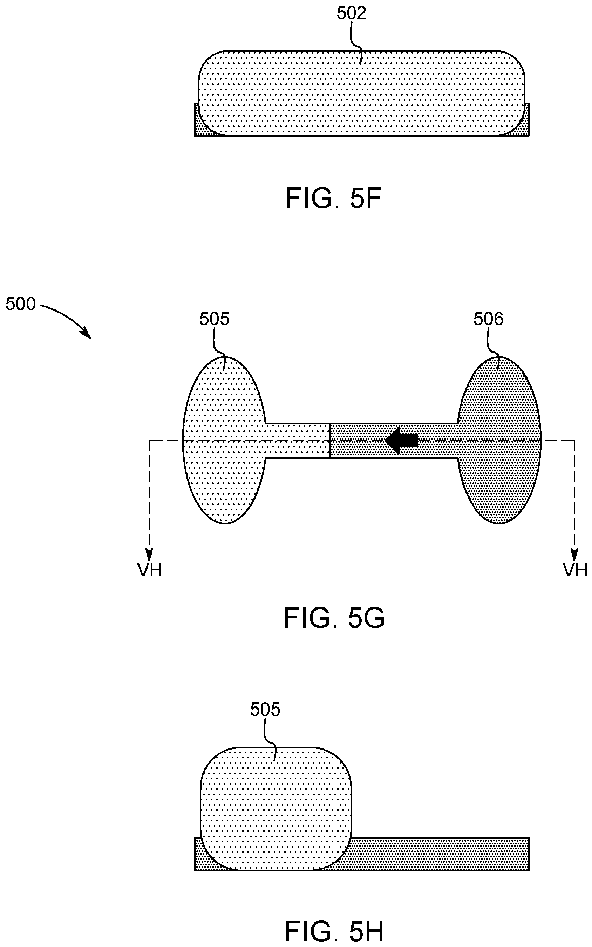

Fig. 5 shows a schematic example of a metrology sensor 500, wherein the displaceable matter comprises a liquid or gel. Said sensor is lithographically defined 500, shown in top view in Fig. 5A and arranged in two extremity areas 501 and a connecting area 502 connecting the two extremity areas 501. 'Extremity area' and 'connecting area' shall be construed broadly to include any suitable shape having two ends towards which the liquid or gel can be displaced. This may include, for example, a single line area. Fig. 5B shows a side view of Fig. 5A, wherein the sensor is defined on the substrate by lithography. Fig. 5C shows the defined sensor 500 wherein a liquid or a gel 502 is deposited on top of the sensor and occupying all the available space. Fig. 5D is a side view of the sensor and liquid or gel shown in Fig. 5C. Fig. 5E shows the shape of the defined sensor with the liquid or gel 502 deposited on top, which allows the liquid or gel to be displaced towards one of the extremity areas upon application of the physical process 504. The physical process may be, for example, a drying process, a temperature change, a phase change or vibrations. The physical stressor may cause tension or instability in the liquid or gel. Fig. 5F is a side view of Fig. 5E. The application of the physical stressor forces the liquid or gel to move towards one of the extremity areas, typically driven by surface energy minimization of the liquid or gel. This effectively creates an observable physical record of the displacement. Fig. 5G shows the displacement of the liquid or gel 502 towards the left extremity area 505, whereas the right extremity area 506 is empty from liquid or gel due to the displacement. The liquid or gel may be adapted to return to the resting state upon release or deactivation of the physical stressor, by physical processes such as increasing water content in air or ultrasound sonication. This may effectively allow to reuse the metrology device a number of times by resetting the device into its initial state. Fig. 5H shows a side view of Fig. 5G.

Preferably, the displaceable matter is displaceable in a plane of the surface of the substrate, in embodiments wherein the displaceable matter is comprised by liquid or gel, or solid matter. Moreover, the displacement of the matter may create an observable physical record in the displaced state. This effectively may transduce a nanometric imperfection to the presence or absence of an observable structure or change in a structure larger than 100 nm in size, which may be easily detected optically.

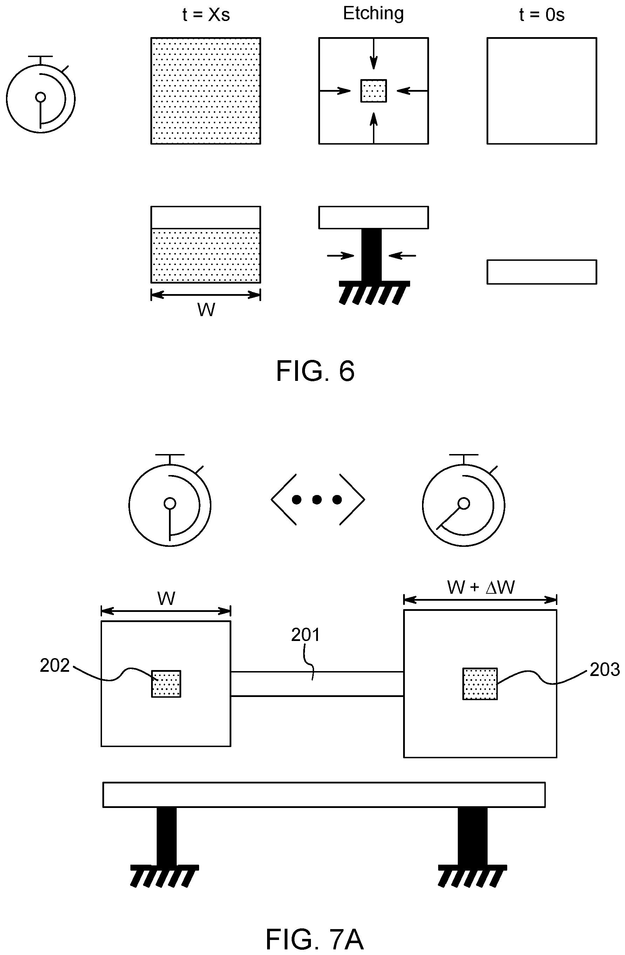

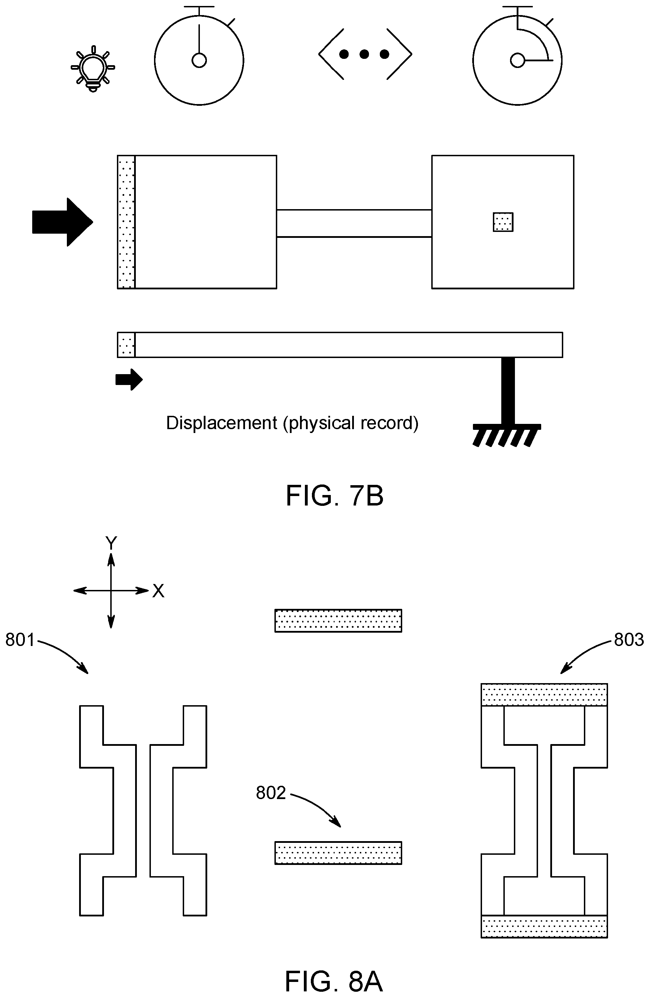

In the case of mechanical actuators, each mechanical actuator or each two extremity areas of the gel or liquid may represent a timer. Each timer may define an expected triggering time for the mechanical actuator or extremity area to reach the displaced state upon application of a physical stressor. The concept of 'timers' can be illustrated as in the example of Fig. 6. In Fig. 6, one actuator is etched. The etching process starts at a given time. The actuator is laterally etched. Since the etching speed and the width of the actuators are known, an expected time for etching the whole actuator can be provided. Fig. 7 shows a further illustration of how the timers can be used to obtain physical records on the substrate that can be used to detect and/or quantify manufacturing inaccuracies made by a lithographic apparatus. In fig. 7A two actuators 202 and 203 are designed such that 203 has a greater width, hence its 'timer' has a greater predefined timer value. The expected outcome of an etching process is thus that actuator 202 reaches its end state before actuator 203, which is illustrated in fig. 7B. As the linking element 201 reaches its unstrained state, it creates an observable physical record.

The application of a physical stressor leaves the metrology sensor in a state wherein the displaceable matter is displaced towards the direction of the mechanical actuator having a greater triggering time, effectively imprinting the end state of the metrology sensor after actuation. The displacement direction may be reversed depending on the physics of the experiment, for example, in case of compressively stressed displaceable matter. The displacement direction may be in the plane of the substrate, or out-of-plan, or a combination of both. A single metrology sensor comprises a minimum of two actuators, with the possibility of adding additional actuators in different directions of the surface of the substrate, allowing for the fabrication of a metrology sensor wherein the displaceable matter can displace in the two dimensions of the surface.

Fig. 3 shows an illustration of a metrology sensor 300, wherein two actuators 302 and 303 are designed with a different width and hence having a predefined difference in triggering time upon activation. Defining actuators with different triggering times allows to quantify manufacturing inaccuracies in the metrology sensors. The displaceable matter 301 will preferentially move upon activation of the activators to the right displaced state 305 and not to the left displaced state 304, due to a higher triggering time of the right actuator 303. Should the displaced state be to the left, it becomes known that a lithographic error in the metrology sensor was made by the lithographic system that overcame the bias in triggering times, which may be used to quantify the error made spatially. Defining actuators gradually having less difference, until they are identical, allows to identify an unknown physical bias, such as an edge placement error induced by the lithographic apparatus during the fabrication process. In one embodiment, each mechanical actuator or extremity area is designed such that its size is proportional to the predefined amount of time it takes to reach the end state, corresponding to the expected triggering time of an actuator.

Fig. 4A shows an example of an array 400 of binary metrology sensors 401 distributed on the substrate. Such array comprises metrology sensors arranged in an *MxN* matrix configuration, wherein *M* ≥ *2* and *N* ≥ 2 . The pattern defines an array of at least 10 metrology sensors, allowing to measure the end state of several metrology sensors to gather information of the lithographic apparatus inaccuracies until a statistically significant result is obtained. Within the same array, different biases can be designed on each sensor, allowing to quantify and test the precision limit of the lithography. Ideally, the precision limit of the lithographic apparatus is achieved when the bias difference between the actuators is sub-1 nm, giving the sensors a random displacement upon activation. An array may refer to a set of discrete metrology sensors not necessarily distributed over one contiguous area, and not necessarily arranged in any specific periodic or aperiodic pattern, with or without other intervening structures. Fig. 4B shows the bitmap or matrix barcode representation of the array 400 of metrology sensors 401. Similar to a barcode reader reading a matrix barcode, any optical system able to discriminate the end state of the metrology sensors can read the entirety of encoded data in it, provided proper instructions are known or given to interpret the string of bits.

The herein disclosed metrology sensor may be run a number of times, such as at least 5 times, or at least 10 times, in parallel on a substrate by patterning many metrology sensors and performing the activation of all sensors simultaneously. The number of times may be greater than 100, greater than a million or even as large as a billion times and more on a single substrate. By detecting the results of a number of experiments, statistics can be obtained which may be used to measure inaccuracies in lithographic patterning. This is because it is known which of the actuators should elapse first since their preset times are lithographically designed according to their size. If the statistics diverge from the expected results, the actuators have slightly different preset times than designed, indicating that the tool has made errors in the lithography. For example, as shown in the first row of devices in Fig. 4, it is possible to design sensors containing actuators having identical preset times, such that it is expected that each of the actuators has a 50% probability to elapse first. In this example 50% of the actuators are shown to be in the up or and 50% in the down final state. If an imbalance is detected in the statistics, where for example one of the actuators has elapsed first with 80% probability, it can be understood that the lithographic apparatus has introduced a bias resulting in one of the actuators having consistently larger islands than the other.

The disclosed metrology sensor may also be configured to not only sense but obtain a quantitative measurement of an inaccuracy, such as an edge placement error, introduced by a lithographic apparatus. This is done by patterning sensors with known biases in preset times, or equivalently using the timer-based implementation of Fig. 6, known size biases. For example, by patterning sensors with 4 nm bias between the end-state and observing that one side elapses first with 100% probability means that the accumulation of errors in the tool is less than 4 nm. It is possible to compile the data from many sensors having different known nanometric or sub-nanometric biases to compile a statistical output curve which may be used to assess the noise floor of the metrology technique under the given process conditions involved in the construction of the individual metrology sensors.

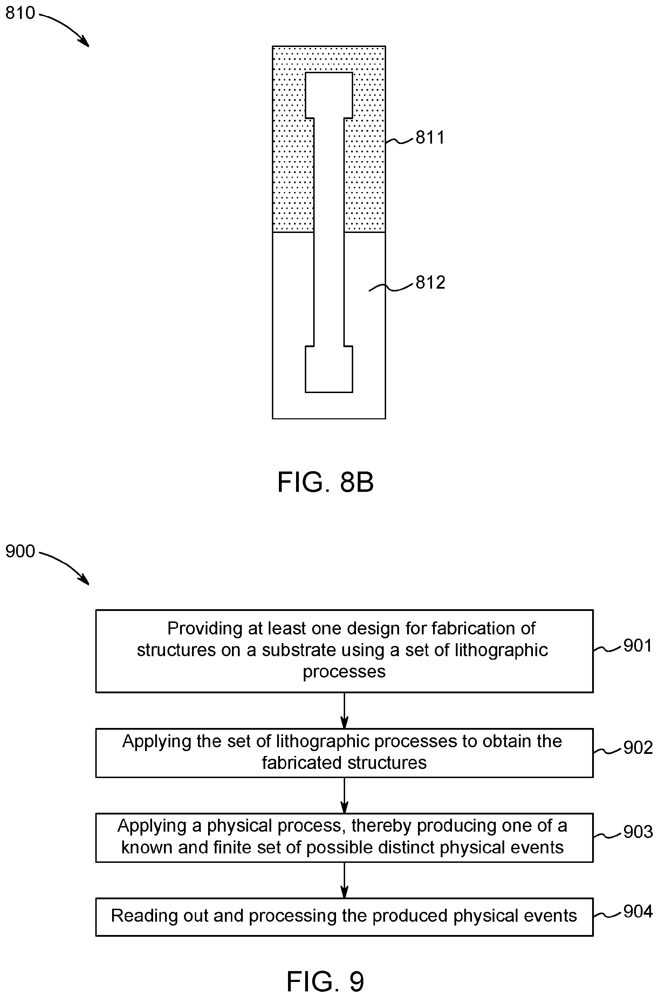

The disclosed metrology sensor may produce independent statistics about different EPEs induced by a lithographic apparatus. For example, it is possible to generate statistics that quantify overlay error in X, but that is independent from overlay errors in Y, as shown in Fig. 8. It is also possible to quantify overlay independently from quantification of CDU, as shown in Fig. 8. In some instances, it is not possible to quantify one component of EPE independent from another component of EPE, in which case statistics from different metrology sensors aimed at quantifying a specific set of EPE components may be used to remove the contribution of those EPE components to obtain an accurate measurement of the remaining EPE components.

The step of imaging the metrology sensors to detect and/or quantify manufacturing inaccuracies made by the lithographic apparatus may comprise microscope imaging of the structures on the substrate. Such imaging characterization technique is preferably a microscopy technique such as optical and alternatively electron or ion microscopy, electrical characterization or ellipsometry or scatterometry. The use of optical microscope allows to measure in a single frame a number of metrology sensors due to the typical large field of view of the acquired frames with this technique, compared with electron microscopy for example. An advantage of the disclosed metrology sensor and method to use it is that nanometric differences induced during a lithography process can be detected macroscopically, by using of said sensors, with an optical microscope that initially does not have spatial resolution to detect the original nanometric differences. Advantageously, the technique is compatible with generating metrology data at the single line level, which can be done by a CD-SEM but not by interferometry, scatterometry and optical image measurements that use a statistical measurement sampling a large area of at least several micrometers of side length encompassing at least several individual structures. Furthermore, the metrology data produced by the metrology sensors becomes independent from the resolution limitation and sources of noise and uncertainty of the optical microscope used to read the data.

In one embodiment, the metrology sensor assembly comprises a substrate; an array of metrology sensors, each metrology sensor comprising a plurality of mechanical actuators connected by at least one linking element in a strained state. In one embodiment, each mechanical actuator is adapted to trigger a mechanical actuation to reach an end state in a predefined amount of time upon initiation of an etching process, wherein each linking element reaches an unstrained state when one of the mechanical actuators reaches its end state. The substrate preferably comprises a semiconductor substrate of a determined out of plane crystal orientation with a defined out of plane crystal orientation, wherein each metrology sensors comprises two mechanical actuators or two liquid actuators.

The herein disclosed metrology sensor may be used in "noise sensing mode", where many sensors are patterned with actuators that are identical or have a range of discrete known biases for quantification, the smallest of which being the smallest controllable increment that lithographic apparatus can produce reliably which may be the minimum step size in an electron beam lithographic apparatus, or the minimum controllable stage step size. The minimum step size can also broadly be interpreted as the typical minimum grid resolution used to in CAD to design patterns, but may also be induced by a controllable and known change in CD or CDU of the patterns or part of the patterns as a result of a particular lithographic process. This sensing mode may be used to characterize a noise floor of the lithographic apparatus in terms of EPEs, which may be used to compare the performance of different lithographic apparatus or processes involved in the construction of the disclosed metrology sensors. For example, if changing a specific process parameter in the lithographic apparatus improves the statistics (i.e., results in fewer errors in the end-state of the sensors), it implies higher edge placement fidelity and the same parameters may be used in other fabrication processes to achieve results closer to the ideal. By extension, the noise sensor may be used to optimize any process parameters of any lithographic apparatus or process step that results in fewer errors in the end-state of the sensors in order to minimize CD, LCDU, stochastics, and roughness such as LER and LWR. The noise sensing mode may be further used to characterize the noise floor of the metrology sensors patterned by a lithographic apparatus, the statistics of which may be used as reference for the sensor in "shift sensing mode" (described below) to obtain higher accuracy and precision of EPE quantification.

The herein disclosed metrology sensor may, alternatively, or additionally, be used in a "shift sensing mode", where the pattern of a metrology sensor is intentionally divided in two or more separate but complementary patterns that do not work as metrology sensors individually, but that may form a complete pattern working as a metrology sensor when combined in two or more separate exposures in the same lithography step or separate lithography steps, as illustrated in Fig. 8A and 8B. For example, a first pattern may define part of the actuators as well as the linking element that connects the actuators, while the second exposure 802 only defines the rest of the actuators. When the complete pattern is obtained in two exposures, a translational error in the alignment between the first exposure, which defines the pattern 801, and the second exposure, which defines the pattern 802, due to overlay errors for example, will generate a detectable imbalance in the statistics since the top island will be consistently smaller or larger than the bottom island, depending on the shift direction. The complementary patterns may be present in the same mask at different locations or be present in two or more distinct masks at any location within the masks. The complementary patterns may be stitched together by displacement of the wafer stage or of the reticle stage or both. When the complementary patterns are present in the same mask, the resulting metrology sensors may sense and quantify registration errors and CDU among others. When present in different masks, the metrology sensors may be used to sense overlay, among others. A wide range of options for splitting a pattern into two or more complementary parts is possible, each potentially sensing different EPEs dependently or independently from other EPEs. For example, EPE contributions in X and Y may be sensed independently. Moreover, the complementary patterns may be exposed in many ways. For example, the complementary patterns may be exposed such that the complete pattern becomes as initially designed but may also be exposed with a controlled misalignment in order to force a bias which may be used to quantify errors. For example, the complete pattern, as designed in the CAD, may be expected to produce statistically balanced results, due for example to a mirror symmetry in the pattern, but in practice may instead produce a systematic imbalance indicative of an overlay, registration, or stage error. Exposing the complementary patterns with an intentional controlled translation in X or in Y between exposures may produce more balanced statistics indicative of a final pattern closer to the CAD, which may be used to identify and quantify the error that produced the imbalance. Furthermore, complementary patterns may form many different metrology sensors by repeating complementary exposures. Several complementary patterns may also be present to form several complete metrology sensors in parallel. There may also be more than one way of stitching different complementary patterns in different exposures to obtain complete patterns working as metrology sensors. By splitting the pattern into one or more parts that affect the metrology data both when the constituent parts are misplaced with respect to one another (e.g. due to overlay error) or when the parts are of a different size (e.g. due to CD error), this shift sensing mode may be used for sensing EPEs. The shift sensing mode may be used for a variety of applications, including sensing of EPEs such as overlay, rotational errors, registration errors, drift in stage or beam over time, stage stitching errors, CDU and LCDU among others. The shift sensing mode may be of further interest for characterizing a lithographic apparatus, or one of its sub-parts, such as a stage, a beam deflection system, an overlay alignment system or a mask, among others. The strategy of dividing a pattern into multiple parts as well as noise-sensing may also be used to optimize proximity effect correction strategies for optical and electron-beam lithography, using both for single and multi-patterning approaches.

Fig. 8A and 8B show examples of cut patterns of a metrology sensor with rectangular and square actuators in a positive tone resist (a radiation sensitive polymer used in lithographic patterning) which, when exposed separately to fabricate a complete metrology sensor, may sense and quantify misalignments, including overlay and registration, and differences in size including CDU, among others.

Fig. 8A shows a metrology sensor design 803 consisting of cut patterns 801 and 802 able to sense and quantify misalignments in Y independently from misalignments in X. Rotating this structure 90° allows for sensing and quantification of misalignment in X independently from misalignments in Y. An additional specificity of this design is that a misalignment contributes to changing both actuators in opposite directions. In other words, this design amplifies a misalignment twofold thereby increasing the sensitivity of the metrology sensor by a factor of 2. An intentional controlled stage displacement to induce an imbalance or compensate an imbalance between actuators may be used for quantifying errors. Yet another specificity of this design is that it is insensitive to CDU due to the two-fold mirror symmetry, which makes this design able to sense and quantify alignment inaccuracies independently from CD or CDU inaccuracies.

Fig 8B shows an example of cut patterns 811 and 812 of a metrology sensor 810 with square actuators in a positive tone resist which, when exposed separately into a complete metrology sensor, may sense and quantify CDU independently from small misalignment inaccuracies such as overlay and registration, among others.

The herein disclosed metrology sensor may, alternatively, or additionally, be used in a "failure sensing mode", wherein the displaceable matter not reaching the displaced state may be used to sense and quantify manufacturing inaccuracies such as EPEs. For example, if a manufacturing inaccuracy induces a physical discontinuity in the linking element, the experiment cannot produce displacement of matter that may be interpreted as the displaced state of the metrology sensor, and thus is interpreted as failure of the metrology sensor. A failure of the metrology sensor produces useful data since it indicates that the pattern was not produced as expected. For example, it is well-known that very narrow lines used in IC manufacturing may break stochastically, which negatively affect the yield of semiconductor devices, in particular in EUV scanners. The failure sensing mode may be used to sense stochastically broken lines since a breaking of a linking element will not result in the expected displaced state, for example when the linking element is a beam. Metrology sensors may be intentionally designed to produce experiments that fail or have a chance of failure since any deviation from an expected failure or non-failure behavior produces useful metrology data about a lithographic apparatus or process. For example, it may be known that experiments fail to produce displacement of matter that may be interpreted as the displaced state of the metrology sensor when a specific dimension of the structure is smaller than 30 nm; if metrology sensors designed above that size consistently fail to produce metrology data, it may be interpreted as the actual CD being smaller than 30 nm, which is smaller than the expected CD. The failure sensing mode may be used in noise sensing mode or in shift sensing mode, or vice versa, noise and shift sensing modes may be used in failure sensing mode. By merging different sensing modes, the detection of metrology sensors that fail to produce metrology data enables further sensing and quantifying of EPEs.

Fig. 9 shows a flow chart of an example of the presently disclosed method 900 for detecting and/or quantifying manufacturing inaccuracies. The method comprises the step of providing at least one design for fabrication of structures on a substrate using a set of the lithographic processes, the at least one pattern defining an array of metrology sensors, wherein each metrology sensor is adapted to produce one of a known and finite set of possible distinct physical events upon application of a physical process 901; applying the set of lithographical processes to obtain the fabricated structures 902; applying the physical process, thereby producing one of the known and finite set of possible distinct physical event for each metrology sensor 903; reading out the produced physical events of all metrology sensors and processing the produced physical events 904.

## Claims

1. A method (900) for detecting and/or quantifying manufacturing inaccuracies made by a lithographic process, comprising the steps of:
providing (901) at least one design for fabrication of structures on a substrate (204) using a set of lithographic processes, wherein the fabricated structures define an array (400) of metrology sensors (100; 200; 300; 401), wherein each metrology sensor (100; 200; 300; 401) is adapted to produce one of a known and finite set of possible distinct and discrete physical events upon application of a physical process, wherein the produced physical event:
is unknown before the application of the physical process,
is dependent on manufacturing inaccuracies generated by at least one of the set of lithographic processes,
is a displaced state (104; 105) of the fabricated structure, or has one or more physical entities associated with the fabricated structure present that were absent before the application of the physical process;
applying (902) the set of lithographic processes to obtain the fabricated structures;
applying (903) the physical process, thereby producing one of the known and finite set of possible distinct and discrete physical events for each metrology sensor (100; 200; 300; 401);
reading out (904) the produced physical events of all metrology sensors (100; 200; 300; 401); and
processing (904) the produced physical events of all metrology sensors (100; 200; 300; 401) to detect and/or quantify manufacturing inaccuracies made by the lithographic process,
**characterized in that**
the produced physical event is larger than the inaccuracies, and
wherein, after having performed said steps, each metrology sensor (100; 200; 300; 401) contains data about the inaccuracies made by the lithographic process.

2. The method (900) according to claim 1, wherein the produced physical events are visibly distinguishable from the other physical events of the set of possible distinct and discrete physical events.

3. The method (900) according to any one of the preceding claims, wherein the manufacturing inaccuracies originate from an edge placement error, wherein the edge placement error is smaller than 5 nm, or wherein the edge placement error is smaller than 1 nm.

4. The method (900) according to any one of the preceding claims, wherein the step of processing (904) the produced physical events comprises computationally processing the produced physical events.

5. The method (900) according to claim 4, comprising the step of applying Boolean logic to the produced physical events based on expected physical results from the at least one design.

6. The method (900) according to any one of claims 4-5, comprising the step of constructing probability distributions of counts of produced physical events against one or more varied design parameters for the design.

7. The method (900) according to any one of the preceding claims, wherein each metrology sensor (100; 200; 300; 401) comprises displaceable matter (101) configured in a resting state and distributed over a local area, wherein the displaceable matter (101) is adapted to reach a displaced state (104; 105) within the local area in a displacement process upon application of the physical process, wherein the displaceable matter (101) is in the resting state when the fabricated structures on the substrate (204) is obtained from the lithographic process.

8. The method (900) according to any one of the preceding claims, wherein the physical process is applied to each metrology sensor (100; 200; 300; 401) for a predefined period of time.

9. The method (900) according to any one of the preceding claims, wherein the physical event is a change in shape, size or placement of a part of or the whole of the structure, preferably wherein the change in shape, size or placement of a part of or the whole of the structure is larger than 10 nm.

10. The method (900) according to any one of the preceding claims, wherein each metrology sensor (100; 200; 300; 401) comprises a plurality of mechanical actuators (202; 203) connected by at least one linking element (201) in a strained state representing the resting state, wherein each mechanical actuator (202; 203) is adapted to trigger a mechanical actuation to reach an end state in a predefined amount of time upon initiation of an etching process, and wherein each linking element (201) reaches an unstrained state representing the displaced state (104; 105) when one of the mechanical actuators (202; 203) reaches its end state, and wherein the step of simultaneously applying the physical process to each metrology sensor (100; 200; 300; 401) for at least a predefined period of time comprises simultaneously etching the array (400) of metrology sensors (100; 200; 300; 401) for at least a predefined period of time.

11. The method (900) according to claim 10, wherein the end state of a mechanical actuator (202; 203) corresponds to a partial or complete etching of the mechanical actuator (202; 203) to a degree that it releases the linking element (201) to which it is connected.

12. The method (900) according to claim 7, wherein the displaceable matter (101) of each metrology sensor (100; 200; 300; 401) comprises liquid or gel (502), wherein the liquid or gel (502) is displaced to the displaced state (104; 105) upon application of the physical process, and wherein the step of simultaneously applying the physical process to each metrology sensor (100; 200; 300; 401) for at least a predefined period of time comprises simultaneously changing a temperature or phase of the liquid or gel (502), or applying vibrations or evaporation.

13. The method (900) according to claim 12, wherein the liquid or gel (502) is arranged in two extremity areas (501) and a connecting area connecting the two extremity areas (501), wherein the liquid or gel (502) is displaced towards one of the extremity areas (501) upon application of the physical process.

14. The method (900) according to any one of claims 10-13, wherein each mechanical actuator (202; 203) or each two extremity areas (501) of the gel or liquid (502) represents a timer, wherein the timer defines an expected triggering time for the mechanical actuator (202; 203) or extremity area (501) to trigger the displaceable matter (101) to reach the displaced state (104; 105) upon application of the physical process and/or wherein each mechanical actuator (202; 203) or extremity area (501) is designed such that its size is proportional to the predefined amount of time it takes to reach the end state, and which corresponds to the expected triggering time of the timer.

15. A metrology system, comprising:
a lithographic apparatus configured to pattern a radiation sensitive resist, such as a polymer, on a substrate (204) to fabricate a structure using a design comprising an array (400) of metrology sensors (100; 200; 300; 401), wherein each metrology sensor (100; 200; 300; 401) is adapted to produce one of a known and finite set of possible distinct and discrete physical events upon application of a physical process, wherein the produced physical event:
is unknown before the application of the physical process,
is dependent on manufacturing inaccuracies generated by the lithographic apparatus, and
is a displaced state (104; 105) of the fabricated structure, or has one or more physical entities associated with the fabricated structures present that were absent before the application of the physical process,
a system adapted to apply the physical process to each metrology sensor (100; 200; 300; 401),
**characterized in that**
the produced physical event is larger than the inaccuracies, and
wherein, after having performed said steps, each metrology sensor (100; 200; 300; 401) contains data about the inaccuracies made by the lithographic process.

## Patentansprüche

1. Verfahren (900) zum Detektieren und/oder Quantifizieren von Fertigungsungenauigkeiten, die durch einen lithografischen Prozess verursacht werden, umfassend die Schritte:
Bereitstellen (901) wenigstens eines Designs zur Herstellung von Strukturen auf einem Substrat (204) unter Verwendung eines Satzes von lithografischen Prozessen, wobei die hergestellten Strukturen ein Array(400) von Metrologiesensoren (100; 200; 300; 401) definieren, wobei jeder Metrologiesensor (100; 200; 300; 401) angepasst ist, um eines von einem bekannten und endlichen Satz von möglichen unterschiedlichen und diskreten physischen Ereignissen bei Anwendung eines physischen Prozesses zu produzieren, wobei das produzierte physische Ereignis:
vor der Anwendung des physischen Prozesses unbekannt ist,
von Fertigungsungenauigkeiten abhängig ist, die durch wenigstens einen des Satzes von lithografischen Prozessen erzeugt werden, ein verlagerter Zustand (104; 105) der hergestellten Struktur ist, oder eine oder mehrere physische Entitäten aufweist, die mit der hergestellten Struktur assoziiert sind, die vorhanden sind, die vor der Anwendung des physischen Prozesses abwesend waren;
Anwenden (902) des Satzes von lithografischen Prozessen, um die hergestellten Strukturen zu erhalten;
Anwenden (903) des physischen Prozesses, wodurch eines des bekannten und endlichen Satzes von möglichen unterschiedlichen und diskreten physischen Ereignissen für jeden Metrologiesensor (100; 200; 300; 401) produziert wird;
Auslesen (904) der produzierten physischen Ereignisse aller Metrologiesensoren (100; 200; 300; 401); und
Verarbeiten (904) der produzierten physischen Ereignisse aller Metrologiesensoren (100; 200; 300; 401), um Fertigungsungenauigkeiten zu detektieren und/oder zu quantifizieren, die durch den lithografischen Prozess verursacht werden,
**dadurch gekennzeichnet, dass**
das produzierte physische Ereignis größer als die Ungenauigkeiten ist, und
wobei, nach Durchführen der Schritte, jeder Metrologiesensor (100; 200; 300; 401) Daten über die Ungenauigkeiten enthält, die durch den lithografischen Prozess verursacht wurden.

2. Verfahren (900) nach Anspruch 1, wobei die produzierten physischen Ereignisse von den anderen physischen Ereignissen des Satzes von möglichen unterschiedlichen und diskreten physischen Ereignissen sichtbar unterscheidbar sind.

3. Verfahren (900) nach einem der vorangehenden Ansprüche, wobei die Fertigungsungenauigkeiten von einem Kantenplatzierungsfehler stammen, wobei der Kantenplatzierungsfehler kleiner als 5 nm ist, oder wobei der Kantenplatzierungsfehler kleiner als 1 nm ist.

4. Verfahren (900) nach einem der vorangehenden Ansprüche, wobei der Schritt des Verarbeitens (904) der produzierten physischen Ereignisse rechnerisches Verarbeiten der produzierten physischen Ereignisse umfasst.

5. Verfahren (900) nach Anspruch 4, umfassend den Schritt des Anwendens von Boolescher Logik auf die produzierten physischen Ereignisse basierend auf erwarteten physischen Ergebnissen von dem wenigstens einen Design.

6. Verfahren (900) nach einem der Ansprüche 4-5, umfassend den Schritt des Konstruierens von Wahrscheinlichkeitsverteilungen von Zählungen von produzierten physischen Ereignissen gegen einen oder mehrere variierte Designparameter für das Design.

7. Verfahren (900) nach einem der vorangehenden Ansprüche, wobei jeder Metrologiesensor (100; 200; 300; 401) verlagerbare Materie (101) umfasst, die in einem Ruhezustand konfiguriert und über einen lokalen Bereich verteilt ist, wobei die verlagerbare Materie (101) angepasst ist, um einen verlagerten Zustand (104; 105) innerhalb des lokalen Bereichs in einem Verlagerungsprozess bei Anwendung des physischen Prozesses zu erreichen, wobei die verlagerbare Materie (101) in dem Ruhezustand ist, wenn die hergestellten Strukturen auf dem Substrat (204) aus dem lithografischen Prozess erhalten werden.

8. Verfahren (900) nach einem der vorangehenden Ansprüche, wobei der physische Prozess auf jeden Metrologiesensor (100; 200; 300; 401) für eine vordefinierte Zeitdauer angewendet wird.

9. Verfahren (900) nach einem der vorangehenden Ansprüche, wobei das physische Ereignis eine Änderung in Form, Größe oder Platzierung eines Teils von oder der Gesamtheit der Struktur ist, vorzugsweise wobei die Änderung in Form, Größe oder Platzierung eines Teils von oder der Gesamtheit der Struktur größer als 10 nm ist.

10. Verfahren (900) nach einem der vorangehenden Ansprüche, wobei jeder Metrologiesensor (100; 200; 300; 401) eine Vielzahl von mechanischen Aktuatoren (202; 203) umfasst, die durch wenigstens ein Verbindungselement (201) in einem gespannten Zustand verbunden sind, der den Ruhezustand repräsentiert, wobei jeder mechanische Aktuator (202; 203) angepasst ist, um eine mechanische Betätigung auszulösen, um einen Endzustand in einer vordefinierten Zeitmenge bei Initiierung eines Ätzprozesses zu erreichen, und wobei jedes Verbindungselement (201) einen entspannten Zustand erreicht, der den verlagerten Zustand (104; 105) repräsentiert, wenn einer der mechanischen Aktuatoren (202; 203) seinen Endzustand erreicht, und wobei der Schritt des gleichzeitigen Anwendens des physischen Prozesses auf jeden Metrologiesensor (100; 200; 300; 401) für wenigstens eine vordefinierte Zeitdauer gleichzeitiges Ätzen des Array (400) von Metrologiesensoren (100; 200; 300; 401) für wenigstens eine vordefinierte Zeitdauer umfasst.

11. Verfahren (900) nach Anspruch 10, wobei der Endzustand eines mechanischen Aktuators (202; 203) einem teilweisen oder vollständigen Ätzen des mechanischen Aktuators (202; 203) bis zu einem Grad entspricht, dass er das Verbindungselement (201) freigibt, mit dem er verbunden ist.

12. Verfahren (900) nach Anspruch 7, wobei die verlagerbare Materie (101) jedes Metrologiesensors (100; 200; 300; 401) Flüssigkeit oder Gel (502) umfasst, wobei die Flüssigkeit oder das Gel (502) in den verlagerten Zustand (104; 105) bei Anwendung des physischen Prozesses verlagert wird, und wobei der Schritt des gleichzeitigen Anwendens des physischen Prozesses auf jeden Metrologiesensor (100; 200; 300; 401) für wenigstens eine vordefinierte Zeitdauer gleichzeitiges Ändern einer Temperatur oder Phase der Flüssigkeit oder des Gels (502), oder Anwenden von Vibrationen oder Verdampfung umfasst.

13. Verfahren (900) nach Anspruch 12, wobei die Flüssigkeit oder das Gel (502) in zwei Extremitätsbereichen (501) und einem Verbindungsbereich, der die zwei Extremitätsbereiche (501) verbindet, angeordnet ist, wobei die Flüssigkeit oder das Gel (502) in Richtung eines der Extremitätsbereiche (501) bei Anwendung des physischen Prozesses verlagert wird.

14. Verfahren (900) nach einem der Ansprüche 10-13, wobei jeder mechanische Aktuator (202; 203) oder alle zwei Extremitätsbereiche (501) des Gels oder der Flüssigkeit (502) einen Timer repräsentieren, wobei der Timer eine erwartete Auslösezeit für den mechanischen Aktuator (202; 203) oder Extremitätsbereich (501) definiert, um die verlagerbare Materie (101) auszulösen, den verlagerten Zustand (104; 105) bei Anwendung des physischen Prozesses zu erreichen, und/oder wobei jeder mechanische Aktuator (202; 203) oder Extremitätsbereich (501) derart gestaltet ist, dass seine Größe proportional zu der vordefinierten Zeitmenge ist, die es dauert, den Endzustand zu erreichen, und die der erwarteten Auslösezeit des Timers entspricht.

15. Metrologiesystem, umfassend:
eine lithografische Vorrichtung, die konfiguriert ist, um einen strahlungsempfindlichen Resist, wie etwa ein Polymer, auf einem Substrat (204) zu strukturieren, um eine Struktur unter Verwendung eines Designs herzustellen, das ein Array (400) von Metrologiesensoren (100; 200; 300; 401) umfasst, wobei jeder Metrologiesensor (100; 200; 300; 401) angepasst ist, um eines von einem bekannten und endlichen Satz von möglichen unterschiedlichen und diskreten physischen Ereignissen bei Anwendung eines physischen Prozesses zu produzieren, wobei das produzierte physische Ereignis:
vor der Anwendung des physischen Prozesses unbekannt ist,
von Fertigungsungenauigkeiten abhängig ist, die durch die lithografische Vorrichtung erzeugt werden, und
ein verlagerter Zustand (104; 105) der hergestellten Struktur ist, oder eine oder mehrere physische Entitäten aufweist, die mit den hergestellten Strukturen assoziiert sind, die vorhanden sind, die vor der Anwendung des physischen Prozesses abwesend waren,
ein System, das angepasst ist, um den physischen Prozess auf jeden Metrologiesensor (100; 200; 300; 401) anzuwenden, **dadurch gekennzeichnet, dass**
das produzierte physische Ereignis größer als die Ungenauigkeiten ist, und
wobei, nach Durchführen der Schritte, jeder Metrologiesensor (100; 200; 300; 401) Daten über die Ungenauigkeiten enthält, die durch den lithografischen Prozess verursacht wurden.

## Revendications

1. Procédé (900) de détection et/ou de quantification des imprécisions de préparation d'un procédé lithographique, comprenant les étapes de :
la fourniture (901) d'au moins une conception pour la fabrication de structures sur un substrat (204) utilisant un ensemble de procédés lithographiques, dans lequel les structures fabriquées définissent un réseau (400) de capteurs métrologiques (100 ; 200 ; 300 ; 401), dans lequel chaque capteur métrologique (100 ; 200 ; 300 ; 401) est adapté pour produire l'un des événements physiques distincts et discrets d'un ensemble connu et fini possible lors de l'application d'un processus physique,
dans lequel l'événement physique produit :
est inconnu avant l'application du procédé physique,
dépend des imprécisions de préparation générées par au moins l'un de l'ensemble des procédés lithographiques,
est un état déplacé (104 ; 105) de la structure fabriquée, ou comporte une ou plusieurs entités physiques associées à la structure fabriquée présente qui étaient absentes avant l'application du processus physique ;
l'application (902) de l'ensemble des procédés lithographiques pour obtenir les structures fabriquées ;
l'application (903) du processus physique, produisant ainsi l'un des ensembles connus et finis d'événements physiques distincts et discrets possibles pour chaque capteur de métrologie (100 ; 200 ; 300 ; 401) ;
la lecture (904) des événements physiques produits par tous les capteurs de métrologie (100 ; 200 ; 300 ; 401) ; et
le traitement (904) des événements physiques produits par tous les capteurs de métrologie (100 ; 200 ; 300 ; 401) pour détecter et/ou quantifier les imprécisions de préparation dues au processus lithographique,
**caractérisé en ce que**
l'événement physique produit est plus important que les inexactitudes, et
dans lequel, après avoir effectué lesdites étapes, chaque capteur de métrologie (100 ; 200 ; 300 ; 401) contient des données sur les imprécisions dues au processus lithographique.

2. Procédé (900) selon la revendication 1, dans lequel les événements physiques produits sont visiblement distinguables des autres événements physiques de l'ensemble des événements physiques distincts et discrets possibles.

3. Procédé (900) selon l'une quelconque des revendications précédentes, dans lequel les imprécisions de préparation proviennent d'une erreur de placement de bord, dans lequel l'erreur de placement de bord est inférieure à 5 nm, ou dans lequel l'erreur de placement de bord est inférieure à 1 nm.

4. Procédé (900) selon l'une quelconque des revendications précédentes, dans lequel l'étape de traitement (904) des événements physiques produits comprend le traitement informatique des événements physiques produits.

5. Procédé (900) selon la revendication 4, comprenant l'étape d'application de la logique booléenne aux événements physiques produits en fonction des résultats physiques attendus d'au moins une conception.

6. Procédé (900) selon l'une quelconque des revendications 4-5, comprenant l'étape de construction de distributions de probabilité de comptages d'événements physiques produits en fonction d'un ou plusieurs paramètres de conception variés pour la conception.

7. Procédé (900) selon l'une quelconque des revendications précédentes, dans lequel chaque capteur de métrologie (100 ; 200 ; 300 ; 401) comprend une matière déplaçable (101) configurée dans un état de repos et répartie sur une zone locale, la matière déplaçable (101) étant adaptée pour atteindre un état déplacé (104 ; 105) dans la zone locale lors d'un processus de déplacement par application du procédé physique, dans lequel la matière déplaçable (101) est dans l'état de repos lorsque les structures fabriquées sur le substrat (204) sont obtenues par le procédé lithographique.

8. Procédé (900) selon l'une quelconque des revendications précédentes, dans lequel le processus physique est appliqué à chaque capteur de métrologie (100 ; 200 ; 300 ; 401) pendant une période de temps prédéfinie.

9. Procédé (900) selon l'une quelconque des revendications précédentes, dans lequel l'événement physique est un changement de forme, de taille ou de position d'une partie ou de la totalité de la structure, de préférence dans lequel le changement de forme, de taille ou de position d'une partie ou de la totalité de la structure est supérieur à 10 nm.

10. Procédé (900) selon l'une quelconque des revendications précédentes, dans lequel chaque capteur de métrologie (100 ; 200 ; 300 ; 401) comprend une pluralité d'actionneurs mécaniques (202 ; 203) reliés par au moins un élément de liaison (201) dans un état contraint représentant l'état de repos, dans lequel chaque actionneur mécanique (202 ; 203) est conçu pour déclencher un actionnement mécanique afin d'atteindre un état final dans un délai prédéfini lors du lancement d'un processus de gravure, et dans lequel chaque élément de liaison (201) atteint un état non contraint représentant l'état déplacé (104 ; 105) lorsqu'un des actionneurs mécaniques (202 ; 203) atteint son état final, et dans lequel l'étape d'application simultanée du processus physique à chaque capteur de métrologie (100 ; 200 ; 300 ; 401) pendant au moins une période de temps prédéfinie comprenant la gravure simultanée du réseau (400) de capteurs de métrologie (100 ; 200 ; 300 ; 401) pendant au moins une période de temps prédéfinie.

11. Procédé (900) selon la revendication 10, dans lequel l'état final d'un actionneur mécanique (202 ; 203) correspond à une gravure partielle ou complète de l'actionneur mécanique (202 ; 203) à un degré tel qu'il libère l'élément de liaison (201) auquel il est connecté.

12. Procédé (900) selon la revendication 7, dans lequel la matière déplaçable (101) de chaque capteur de métrologie (100 ; 200 ; 300 ; 401) comprend un liquide ou un gel (502), dans lequel le liquide ou le gel (502) est déplacé vers l'état déplacé (104 ; 105) lors de l'application du procédé physique, et dans lequel l'étape d'application simultanée du procédé physique à chaque capteur de métrologie (100 ; 200 ; 300 ; 401) pendant au moins une période de temps prédéfinie comprend la modification simultanée d'une température ou d'une phase du liquide ou du gel (502), ou l'application de vibrations ou d'évaporation.

13. Procédé (900) selon la revendication 12, dans lequel le liquide ou le gel (502) est agencé dans deux zones d'extrémité (501) et une zone de liaison reliant les deux zones d'extrémité (501), dans lequel le liquide ou le gel (502) est déplacé vers l'une des zones d'extrémité (501) lors de l'application du procédé physique.

14. Procédé (900) selon l'une quelconque des revendications 10 à 13, dans lequel chaque actionneur mécanique (202 ; 203) ou chacune des deux zones d'extrémité (501) du gel ou du liquide (502) représente une minuterie, dans lequel la minuterie définit un temps de déclenchement prévu pour que l'actionneur mécanique (202 ; 203) ou la zone d'extrémité (501) déclenche la matière déplaçable (101) pour atteindre l'état déplacé (104 ; 105) lors de l'application du processus physique et/ou dans lequel chaque actionneur mécanique (202 ; 203) ou zone d'extrémité (501) est conçu de telle sorte que sa taille soit proportionnelle à la durée prédéfinie nécessaire pour atteindre l'état final, et qui correspond au temps de déclenchement prévu de la minuterie.

15. Système de métrologie, comprenant :
un appareil lithographique configuré pour modéliser une réserve sensible aux radiations, telle qu'un polymère, sur un substrat (204) pour fabriquer une structure en utilisant une conception comprenant un réseau (400) de capteurs métrologiques (100 ; 200 ; 300 ; 401), dans lequel chaque capteur métrologique (100 ; 200 ; 300 ; 401) est adapté pour produire l'un des événements physiques distincts et discrets d'un ensemble connu et fini possible lors de l'application d'un processus physique, dans lequel l'événement physique produit :
est inconnu avant l'application du procédé physique,
est dépendant des imprécisions de préparation générées par l'appareil lithographiques, et
est un état déplacé (104 ; 105) de la structure fabriquée, ou comporte une ou plusieurs entités physiques associées aux structures fabriquées qui étaient absentes avant l'application du processus physique,
un système adapté pour appliquer le processus physique à chaque capteur de métrologie (100 ; 200 ; 300 ; 401),
**caractérisé en ce que**
l'événement physique produit est plus important que les inexactitudes, et
dans lequel, après avoir effectué lesdites étapes, chaque capteur de métrologie (100 ; 200 ; 300 ; 401) contient des données sur les imprécisions dues au processus lithographique.
